(19) Europäisches Patentamt
European Patent Office
Office européen des brevets

(11) **EP 4 277 076 A1**

(12) **EUROPEAN PATENT APPLICATION**

(43) Date of publication:
**15.11.2023  Bulletin 2023/46**

(21) Application number: **23161470.2**

(22) Date of filing: **13.03.2023**

(51) International Patent Classification (IPC):
**H02J 7/00** $^{(2006.01)}$

(52) Cooperative Patent Classification (CPC):
**H02J 7/00714; H02J 7/0048; H02J 7/007182**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.05.2022  KR 20220056740**
**20.05.2022  KR 20220062073**

(71) Applicant: **Samsung Electronics Co., Ltd.**
**Suwon-si, Gyeonggi-do 16677 (KR)**

(72) Inventors:
• **Kim, Jinho**
**Suwon-si, Gyeonggi-do 16678 (KR)**
• **Song, Tae Won**
**Suwon-si, Gyeonggi-do 16678 (KR)**

(74) Representative: **Grünecker Patent- und Rechtsanwälte**
**PartG mbB**
**Leopoldstraße 4**
**80802 München (DE)**

(54) **METHOD AND DEVICE WITH ESTIMATING BATTERY STATE**

(57)    A device and method with battery state estimation are disclosed. A method includes charging a battery in a constant current (CC) charging mode, iteratively updating a full state of charge (SOC) value of the battery while in the CC charging mode, when a measured voltage value of the battery is determined to be greater than or equal to a cutoff voltage value, switching from the CC charging mode to a constant voltage (CV) charging mode and charging the battery in the CV charging mode, and iteratively updating the full SOC value while the battery is in the CV charging mode.

FIG. 1

EP 4 277 076 A1

**Description**

BACKGROUND

1. Field

The following description relates to a device and method with battery state estimation.

2. Description of Related Art

A battery state may be estimated in various ways for optimizing battery management. For example, a battery state may be estimated through the integration of currents of a battery or by using a battery model (e.g., an electric circuit model or an electrochemical model).

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is claimed by the independent claims. Preferred embodiments are specified in the dependent claims.

In one general aspect a method includes charging a battery in a constant current (CC) charging mode, iteratively updating a full state of charge (SOC) value of the battery while in the CC charging mode, when a measured voltage value of the battery is determined to be greater than or equal to a cutoff voltage value, switching from the CC charging mode to a constant voltage (CV) charging mode and charging the battery in the CV charging mode, and iteratively updating the full SOC value while the battery is in the CV charging mode.

The iteratively updating the full SOC value in the CC charging mode may include determining whether charging of the battery may have reached a point for updating the full SOC value, when determined that the charging of the battery has reached the point, calculating an average resistance value of the battery for an interval before the point, updating the full SOC value based on correlation information correlating SOC and open-circuit voltage (OCV), the calculated average resistance value, a cutoff current value, and the cutoff voltage value, setting a subsequent point for updating the full SOC value, and when the battery reaches the set subsequent point, iteratively updating the full SOC value based on an average resistance value of the battery for an interval between the point and the subsequent point, the correlation information, the cutoff current value, and the cutoff voltage value.

The calculating the average resistance value may include at points during the interval, calculating a resistance value using a measured voltage value, an estimated OCV value, and a measured electrical current value of the battery, and calculating the average resistance value by averaging the calculated resistance values.

The updating the full SOC value based on the correlation information, the calculated average resistance value, the cutoff current value, and the cutoff voltage value may include multiplying the calculated average resistance value with the cutoff current value, predicting, as an OCV of the battery when the battery may be fully charged, a difference value between the cutoff voltage value and a result of the multiplying, and determining an SOC corresponding to the predicted OCV using the correlation information, and updating the full SOC value based on the determined SOC.

The iteratively updating the full SOC value in the CV charging mode may include determining whether charging the battery may have reached a start point by comparing a first measured current value of the battery being charged in the CV charging mode to a current value at the preset start point, when the charging the battery reaches the start point, setting a point for updating the full SOC value, determining whether the charging the battery may have reached the set point, when the charging the battery reaches the set point, predicting a full charge time of the battery and predicting a residual SOC that remains until the battery may be fully charged, based on the predicted full charge time, and updating the full SOC value based on the predicted residual SOC.

The iteratively updating the full SOC value in the CV charging mode may include setting a subsequent point for updating the full SOC value, when the battery reaches the set subsequent point, iteratively predicting a full charge time of the battery, and iteratively predicting a residual SOC that remains until the battery may be fully charged, based on the iteratively predicted full charge time, and iteratively updating the full SOC value based on the iteratively predicted residual SOC.

The predicting the residual SOC may include predicting the full charge time based on a first time value of a time at which charging the battery has reached the preset start point, a second time value of a time at which charging the battery has reached the preset point, a transformed value of the first measured current value, a transformed value of a result value derived by subtracting a predetermined value from the first measured current value, and a transformed value of the cutoff current value, and predicting the residual SOC based on the predicted full charge time, the second time value, the result value, and the cutoff current value.

The transformed value of the first measured current value, the transformed value of the result value, and the transformed value of the cutoff current value may be values obtained through a logarithmic transformation of the first measured current value, the result value, and the cutoff current value.

The predicting the full charge time may include calculating a first difference value between the transformed value of the cutoff current value and the transformed value of the first measured current value, calculating a second difference value between the transformed value of the result value and the transformed value of the first measured current value, calculating a third difference value between the second time value and the first time value, and predicting the full charge time using the calculated first difference value, the calculated second difference value, the calculated third difference value, and the first time value.

A method of updating the full SOC value in the CC charging mode may differ from a method of updating the full SOC value in the CV charging mode.

The method may further include updating an absolute SOC (ASOC) of the battery using a battery model, determining whether the battery is fully charged when the battery is determined to be fully charged, determining a relative SOC (RSOC) of the battery using a lastly updated full SOC value, the updated ASOC, and an unusable SOC, and displaying an indication of the determined RSOC.

In one general aspect, a method includes charging a battery in a constant current (CC) charging mode, updating a full state of charge (SOC) value of the battery according to a first method while in the CC charging mode, when a measured voltage value of the battery satisfies a cutoff voltage value, switching from the CC charging mode to a constant voltage (CV) charging mode and charging the battery in the CV charging mode, and updating the full SOC value according to a second method in association with the CV charging mode.

The updating the full SOC value according to the first method may include determining whether charging the battery may have reached a point for updating the full SOC value, when determined that the charging the battery has reached the point, calculating an average resistance value of the battery for an interval before the point, and updating the full SOC based on correlation information correlating SOC values and open-circuit voltage (OCV) values, the calculated average resistance value, a cutoff current value, and the cutoff voltage value.

The calculating the average resistance value may include, at points during the interval, calculating a resistance value using a measured voltage value, an estimated OCV value, and a measured current value of the battery, and calculating the average resistance value by averaging the calculated resistance values.

The updating the full SOC value based on the correlation information, the calculated average resistance value, the cutoff current value, and the cutoff voltage value may include multiplying the calculated average resistance value with the cutoff current value, predicting, as an OCV of the battery when the battery may be fully charged, a difference value between the cutoff voltage value and a result of the multiplying, and determining an SOC corresponding to the predicted OCV using the correlation information, and updating the full SOC value based on the determined SOC.

The updating the full SOC value according to the second method may include determining whether the battery may have reached a start point by comparing a first measured current value of the battery in the CV charging mode to a current value at the preset start point, when the charging the battery reaches the preset start point, setting a point for updating the full SOC value, determining whether the battery may have reached the set point, when the charging the battery reaches the set point, predicting a full charge time of the battery and predicting a residual SOC that remains until the battery may be fully charged, based on the predicted full charge time, and updating the full SOC value based on the predicted residual SOC.

The predicting the residual SOC may include predicting the full charge time based on a first time value of a time at which the battery may have reached the start point, a second time value of a time at which the battery may have reached the point, a transformed value of the first measured electrical current value, a transformed value of a result value derived by subtracting a predetermined value from the first measured current value, and a transformed value of the cutoff current value, and predicting the residual SOC based on the predicted full charge time, the second time value, the result value, and the cutoff current value.

The transformed value of the first measured current value, the transformed value of the result value, and the transformed value of the cutoff current value may be values obtained through a transformation of the first measured current value, the result value, and the cutoff current value into a logarithmic scale, respectively.

The predicting the full charge time may include calculating a first difference value between the transformed value of the cutoff current value and the transformed value of the first measured current value, calculating a second difference value between the transformed value of the result value and the transformed value of the first measured current value, calculating a third difference value between the second time value and the first time value, and predicting the full charge time using the calculated first difference value, the calculated second difference value, the calculated third difference value, and the first time value.

The method may further include updating an absolute SOC (ASOC) of the battery using a battery model;

determining whether the battery is fully charged, when the battery is fully charged, determining a relative SOC (RSOC) of the battery using a lastly updated full SOC value, the updated ASOC, and an unusable SOC, and displaying an indication of the determined RSOC.

In one general aspect, an electronic device includes a battery, a charger configured to charge the battery in a constant current (CC) charging mode, and charge the battery in a constant voltage (CV) charging mode when a condition is determined to be satisfied, a first circuit configured to update a full state of charge (SOC) value of the battery according to a first method while in the CC charging mode, update the full SOC value of the battery according to a second method while in the CV charging mode, and determine a relative SOC (RSOC) of the battery using a lastly updated value of the full SOC value, an absolute SOC (ASOC) of the battery, and an unusable SOC, and a processor configured to receive the determined RSOC from the first circuit and display an indication of the received RSOC.

In the first method, the first circuit may be configured to determine whether the battery has reached a point for updating the full SOC value; and when the point is reached, calculate an average resistance value of the battery for an interval before the point, and update the full SOC value based on correlation information correlating SOC values with open-circuit voltage (OCV) values, the calculated average resistance value, a cutoff current value, and the cutoff voltage value.

In the second method, the first circuit may be configured to determine whether the battery has reached a start point by comparing a first measured current value of the battery in the CV charging mode to a current value at the start point, when the charging the battery reaches the start point, set a point for updating the full SOC value, determine whether the charging the battery has reached the set point, when determined that the charging the battery has reached the set point, predict a full charge time of the battery, and predict a residual SOC that remains until the battery is fully charged, based on the predicted full charge time, and update the full SOC value based on the predicted residual SOC.

The first circuit may be configured to iteratively update the full SOC value of the battery according to the first method while in the CC charging mode, and iteratively update the full SOC value of the battery according to the second method while in the CV charging mode.

Other features and aspects will be apparent from the following detailed description, the drawings, and the claims.

BRIEF DESCRIPTION OF THE DRAWINGS

FIG. 1 illustrates an example of an electronic device, according to one or more embodiments.

FIG. 2 illustrates example states of charge (SOCs), according to one or more embodiments.

FIG. 3A illustrates an examples of estimating an absolute state of charge (ASOC), a full state of charge ($SOC_{max}$), and a relative state of charge (RSOC) by an electronic device, according to one or more embodiments.

FIGS. 3B and 3C illustrate examples of relationships between an ASOC, RSOC, and RSOC reference, according to one or more embodiments

FIG. 4A illustrates an example timeline graph of estimating (or updating) SOCmax in a first charging interval by an electronic device, according to one or more embodiments.

FIG. 4B illustrates example intervals of estimating (or updating) SOCmax by an electronic device, according to one or more embodiments.

FIG. 5 illustrates an example timeline of charging current (A) in relation to estimating (or updating) SOCMax in a second charging interval by an electronic device, according to one or more embodiments.

FIG. 6 illustrates an example timeline of charging current (A), in log scale, in relation to estimating (or updating) SOCMax in a second charging interval by an electronic device, according to one or more embodiments.

FIG. 6B illustrates an example timeline related to estimating (or updating) SOCMax in a second charging interval by an electronic device, according to one or more embodiments.

FIG. 7 illustrates an example of estimating (or updating) SOCmax in a second charging interval by an electronic device, according to one or more embodiments.

FIG. 8 illustrates an example of steps for estimating (or updating) SOCmax by an electronic device, according to one or more embodiments.

FIG.9 illustrates an examples of additional steps for estimating (or updating) SOCmax by an electronic device, according to one or more embodiments

FIG. 10 illustrates an example configuration of an electronic device, according to one or more embodiments.

FIG. 11 illustrates an example configuration of a first circuit of an electronic device, according to one or more embodiments.

FIG. 12 illustrates an example of a vehicle, according to one or more embodiments.

FIG. 13 illustrates an example of a battery state estimating method of an electronic device, according to one or more embodiments.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

Also, in the description of example embodiments, detailed description of structures or functions that are thereby known after an understanding of the disclosure of the present application will be omitted when such description will cause ambiguous interpretation of the example embodiments. Hereinafter, examples will be described in detail with reference to the accompanying drawings, and like reference numerals in the drawings refer to same or like elements throughout.

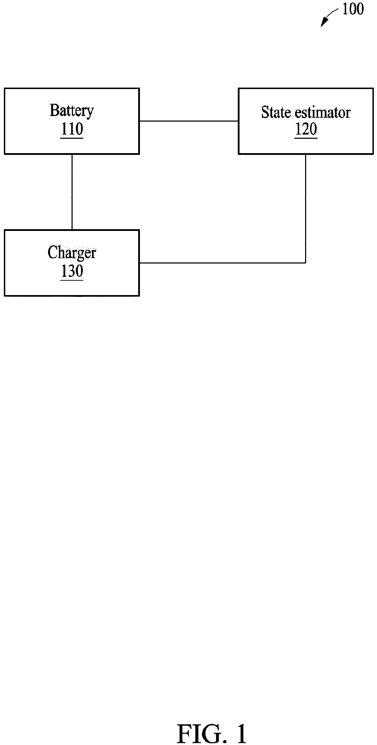

FIG. 1 illustrates an example of an electronic device, according to one or more embodiments.

Referring to FIG. 1, an electronic device 100 may include a battery 110, a state estimator 120, and a charger 130.

The electronic device 100, which is a device using a battery (e.g., the battery 110), may be, for example, a mobile phone, a smartphone, a personal computer (PC), a tablet PC, a laptop, an electronic book device, a smart watch, smart glasses, a head-mounted display (HMD), a smart speaker, a smart television (TV), a smart refrigerator, an electric vehicle, an autonomous vehicle, a smart kiosk, an Internet of things (IoT) device, a walking assist device (WAD), a drone, a robot, an/or the like.

The battery 110 may include, for example, one or more battery cells, battery modules, and/or battery packs.

The charger 130 may charge the battery 110. The electronic device 100 may be connected to an adapter by wire, for example. The charger 130 may receive power from the adapter to charge the battery 110. However, examples are not limited thereto, and the electronic device 100 may be wirelessly connected to a wireless charger e.g., by electromagnetic induction, electromagnetic beam, etc.

The charger 130 may charge the battery 110 in a first charging mode, and then charge the battery 110 in a second charging mode when a certain condition is determined to be satisfied while charging the battery 110 in the first charging mode. For example, the condition may be when a voltage of the battery 110 becomes greater than or equal to a cutoff voltage. The first charging mode may be a constant current (CC) charging mode or a multi-step CC (MCC) charging mode, and the second charging mode may be a constant voltage (CV) charging mode. The CC charging mode may be a mode in which the charger 130 charges the battery 110 with one level of constant current, and the MCC charging mode may be a mode in which the charger 130 charges the battery 110 with multiple levels of constant current at different times. In the MCC charging mode, a charging current of the battery 110 may decrease in stages (in some embodiments, some stages may have increased CC). The CV charging mode may refer to a mode in which the charger 130 charges the battery 110 with a constant voltage. In the CV charging mode, the charging current of the battery 110 may decrease in various ways. As used herein "CC charging" is deemed to include both multi-step CC charging and non-multi-step CC charging.

The state estimator 120 may measure one or more physical properties of the battery 110 using one or more sensors (e.g., a voltage sensor, a current sensor, a temperature sensor, etc.). That is, the state estimator 120 may collect measurement data of the battery 110. The measurement data may include, for example, voltage data, current data, and/or temperature data.

The state estimator 120 may determine or estimate state information of the battery 110 based on the measurement data. The state information may include, for example, information indicating a state of charge (SOC), an absolute SOC (ASOC), a relative SOC (RSOC), an unusable SOC, a state of health (SOH), and/or an abnormal state (whether or not there is abnormality).

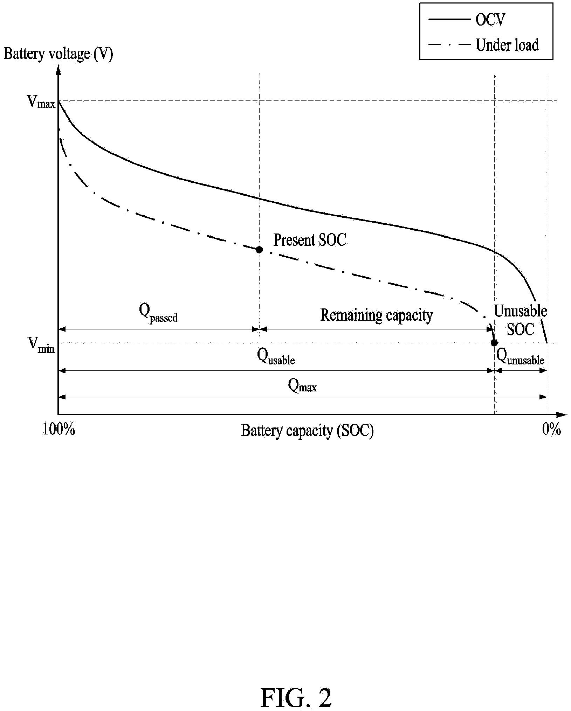

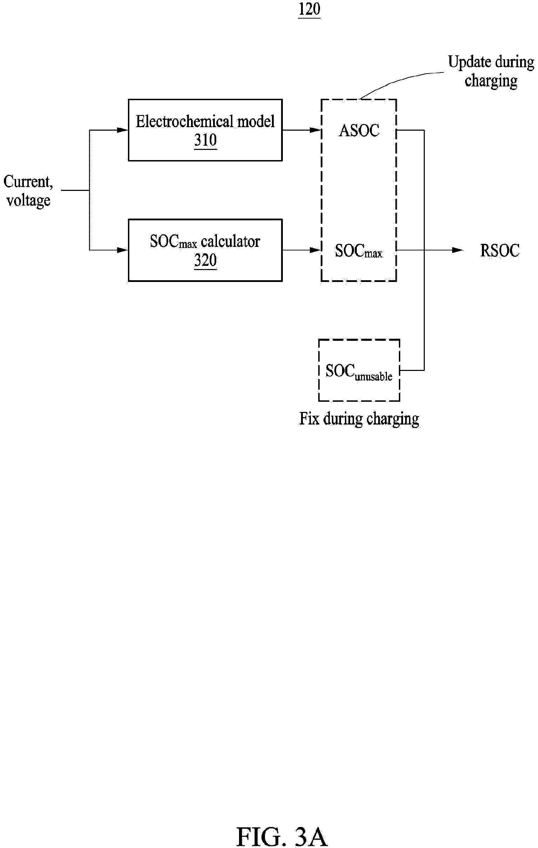

FIGS. 2 and 3A through 3C illustrate examples of estimating an ASOC, a full SOC (SOCmax), and an RSOC by an electronic device, according to one or more embodiments.

An SOC may be a presently available capacity of a battery (out of a total capacity of the battery) with respect to an open-circuit voltage (OCV) and may be represented by Equation 1 below. The SOC may be determined based on an OCV graph shown in FIG. 2. Referring to FIG. 2, $V_{max}$ denotes a full charge voltage which is a voltage when a battery is fully charged, and $V_{min}$ denotes an end-of-discharge voltage (EDV) which is a voltage when a battery is fully discharged with respect to an OCV. For example, $V_{min}$ may be a voltage that is set by a manufacturer, for example, as a cutoff to prevent a battery from being excessively discharged.

## Equation 1

$$SOC = \frac{Q_{max} - Q_{passed}}{Q_{max}}$$

In Equation 1, $Q_{max}$ denotes a total capacity (or a designed capacity) of a battery that is designed based on an OCV, and $Q_{passed}$ denotes a capacity of the battery that has been used up to a present time. Accordingly, "$Q_{max}$ - $Q_{passed}$" may represent a capacity that is available at present based on the OCV (sometimes referred to as Qt). Such a SOC may indicate an ASOC independent of a discharging current and may also be referred to as a present SOC because it indicates a SOC of the battery at a present time.

Referring to FIG. 3A, the state estimator 120 (or the electronic device 100) may input the measurement data of the battery 110 to an electrochemical model 310, and according thereto may estimate an ASOC and a voltage of the battery 110 through the electrochemical model 310. That is to say, the state estimator 120 may obtain the estimated ASOC of the battery 110 and the estimated voltage of the battery 110 using the electrochemical model 310. When a difference between the estimated voltage of the battery 110 and a measured voltage of the battery 110 is in a predetermined range, the state estimator 120 may determine that the electrochemical model 310 accurately estimates the ASOC of the battery 110. However, when the difference between the estimated voltage of the battery 110 and the measured voltage of the battery 110 is out of the range, the state estimator 120 may determine (or infer) that the electrochemical model 310 inaccurately estimates (or erroneously calculates) the ASOC of the battery 110. In this case, the state estimator 120 may perform correction (e.g., on the electrochemical model 310) such that the difference between the estimated voltage of the battery 110 (from the corrected model) and the measured voltage of the battery 110 then falls within the range. For example, the state estimator 120 may determine a state variation (e.g., ΔSOC) is to be corrected (determine by using the difference between the estimated voltage of the battery 110 and the measured voltage of the battery 110) and may update an internal state (e.g., a lithium-ion concentration distribution) of the electrochemical model 310 using the determined state variation. The state estimator 120 may thus more accurately estimate the ASOC of the battery 110 through the updated electrochemical model 310. Accordingly, a difference between (i) an estimated voltage of the battery 110 output by the updated electrochemical model 310 and (ii) the measured voltage of the battery 110 may fall within the range.

Such an electrochemical model-based ASOC estimation is disclosed in U.S Patent Application Publication No. 2021-0116510, the entire disclosure of which is incorporated herein by reference.

The state estimator 120 may periodically update the ASOC of the battery 110 using the electrochemical model 310 while the battery 110 is being charged. Note that where the context indicates, terms like ASOC, SOC, OCV are shorthand references for representations (e.g., values in memory) of such battery properties.

Referring back to FIG. 2, the battery 110 may be being discharged by the application of a current from the battery to a connected load. In the case of actual use, an RSOC based on an under-load (i.e., when loaded) voltage may be used, instead of an SOC based on an OCV. The RSOC may refer to a presently available capacity out of a total available capacity based on a voltage when a current is applied, and may represent a total available capacity from a perspective of a user. The RSOC may be determined by Equation 2 below, based on an under-load graph, an example of which is shown in FIG. 2.

Equation 2

$$RSOC = \frac{Q_{usable} - Q_{passed}}{Q_{usable}}$$

$$= \frac{Q_{max} - Q_{passed} - Q_{unusable}}{Q_{max} - Q_{unusable}}$$

$$= \frac{\dfrac{Q_{max} - Q_{passed}}{Q_{max}} - \dfrac{Q_{unusable}}{Q_{max}}}{1 - \dfrac{Q_{unusable}}{Q_{max}}}$$

$$= \frac{SOC - SOC_{unusable}}{1 - SOC_{unusable}}$$

In Equation 2, $Q_{usable}$ denotes a full charge capacity (FCC), which is a total available capacity based on a voltage when a current is applied as a load is connected to a battery (e.g., the battery 110). $Q_{usable}$ may be determined by a difference between $Q_{max}$ and $Q_{unusable}$ (i.e., $Q_{max}$ - $Q_{unusable}$). $Q_{unusable}$ denotes an unusable capacity as the battery connected to the load reaches an EDV and further discharging is thus limited. $Q_{unusable}$ may vary according to a current magnitude, a temperature, and/or a degradation (or aging) state of the battery.

For example, when a current is output from the battery 110 as a load is connected to the battery 110, an output voltage of the battery 110 may be lower than an OCV. Thus, the under-load graph of FIG. 2 may have a smaller value than an OCV graph. That is, as the current output from the battery 110 increases, a gap between the under-load graph and the OCV graph may increase. As the current output from the battery 110 increases, $Q_{unusable}$ may also increase.

Accurate prediction of an RSOC of the battery 110 may hinge on accurate prediction of $Q_{usable}$ and $Q_{passed}$. However, as described above, $Q_{usable}$ may be determined based on $Q_{unusable}$ , which is affected by the current magnitude and the temperature, and thus accurate prediction might be problematic. Thus, the RSOC may be determined by an equation using a SOC rather than Q, as represented by substitutions leading to Equation 2. The RSOC may be determined based on an SOC and an unusable SOC ("$SOC_{unusable}$" herein). In this case, the SOC may represent an ASOC determined through Equation 1, and $SOC_{unusable}$ may represent a SOC when the battery 110 reaches the EDV by being discharged by the application of a current. $SOC_{unusable}$ may be a SOC at the EDV, which may vary according to a current magnitude, a temperature, and/or a degradation (or aging) state of the battery 110. $SOC_{unusable}$ may also be referred to as SOCEDV.

The state estimator 120 may determine (or estimate) an RSOC of the battery 110 while updating $SOC_{unusable}$ during immediately previous discharging of the battery 110. The state estimator 120 may use a most lastly updated $SOC_{unusable}$ during the immediately previous discharging of the battery 110 to determine (or estimate) an RSOC during charging of the battery 110. $SOC_{unusable}$ used during charging of the battery 110 may be fixed.

A full charging condition may vary according to the use or charging conditions of the battery 110 (e.g., a charging temperature, a battery degradation degree, etc.). For example, when the battery 110 is being charged, the magnitude of resistance may change according to the charging temperature or the battery degradation degree. As the resistance changes, a full SOC, or "SOCmax", and the full charging condition (e.g., a condition under which a voltage of the battery 110 reaches a cutoff voltage and a condition under which a charging current of the battery 110 reaches a cutoff current) may change. SOCmax of the battery 110 may change according to the charging condition of the battery 110, and Equation 2 above may thus change to Equation 3 below.

Equation 3

$$RSOC = \frac{Q_{usable} - Q_{passed}}{Q_{usable}}$$

$$= \frac{Q_{max\_CHG} - Q_{passed} - Q_{unusable}}{Q_{max\_CHG} - Q_{unusable}}$$

$$= \frac{\dfrac{Q_{max\_CHG} - Q_{passed}}{Q_{max}} - \dfrac{Q_{unusable}}{Q_{max}}}{\dfrac{Q_{max\_CHG}}{Q_{max}} - \dfrac{Q_{unusable}}{Q_{max}}}$$

$$= \frac{SOC - SOC_{unusable}}{SOC_{max} - SOC_{unusable}}$$

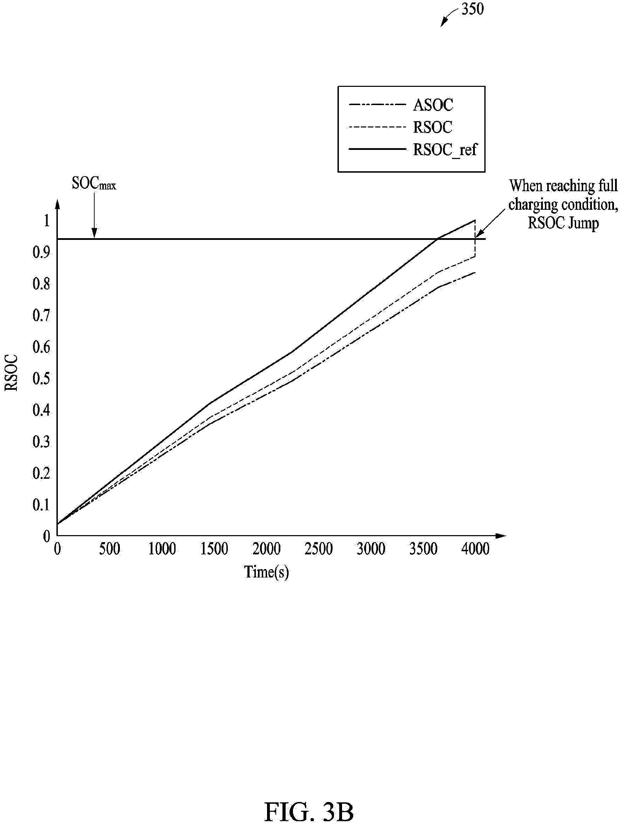

When the charging condition (e.g., the charging temperature, etc.) is constant, SOCmax may be used as a constant (e.g., 1) as represented in Equation 2 above. However, in an environment of actual use where there are various charging conditions, SOCmax may be a variable as represented in Equation 3 above. When SOCmax is used as the constant, there may be a difference between an RSOC estimated during charging of the battery 110 and RSOC_ref, as shown in FIG. 3B. RSOC_ref may refer to a reference RSOC, which indicates an RSOC corresponding to "true." When the battery 110 reaches the full charging condition, an RSOC jump may occur. In the example 350 shown in FIG. 3B, when the battery 110 reaches the full charging condition, an RSOC may not actually be estimated to be 100%, but the RSOC may jump to 100% to inform a user that the battery 110 is fully charged. In this case, an incorrect RSOC may be provided to the user.

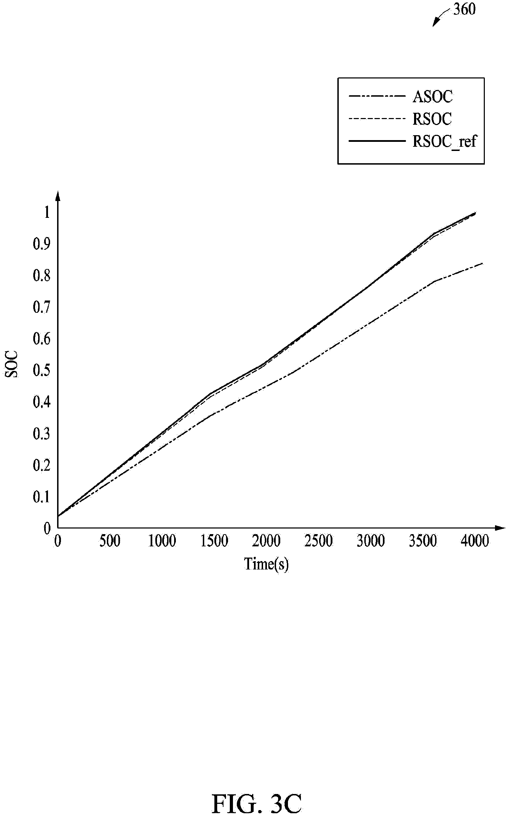

The state estimator 120 (or the electronic device 100) may iteratively update (or estimate) SOCmax while the battery 110 is being charged. The state estimator 120 may update SOCmax using effective resistance in a first charging interval and/or may update SOCmax using a current attenuation characteristic in a second charging interval. The first charging interval may refer to a period during which the charger 120 charges the battery 110 in the first charging mode (e.g., a CC charging mode or an MCC charging mode), and the second charging interval may refer to a period during which the charger 120 charges the battery 110 in the second charging mode (e.g., a CV charging mode). The state estimator 120 may estimate an RSOC based on the updated SOCmax during the first charging interval and/or the second charging interval. As shown in the example 360 of FIG. 3C, there may not be a substantial difference between RSOC and RSOC_ref during charging of the battery 110, and the RSOC jump may not occur even through the time when the battery 110 reaches the full charging condition. Accordingly, the state estimator 120 may more accurately estimate the RSOC and provide the user with an accurate RSOC.

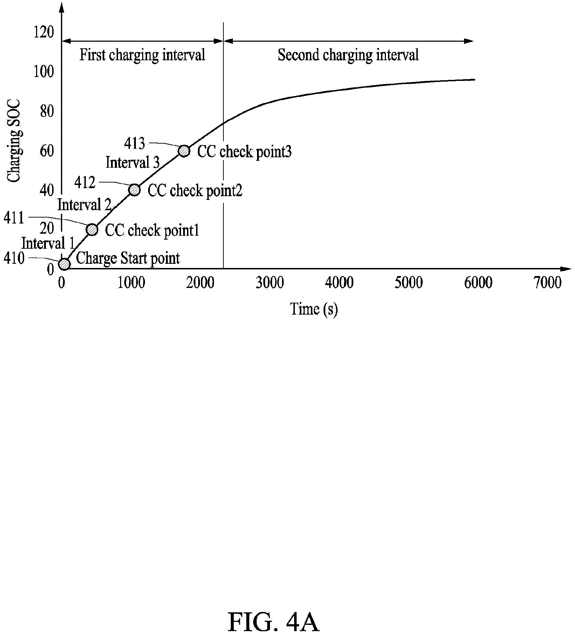

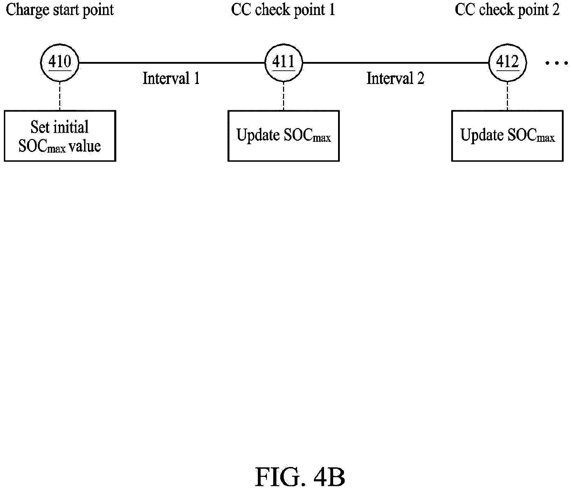

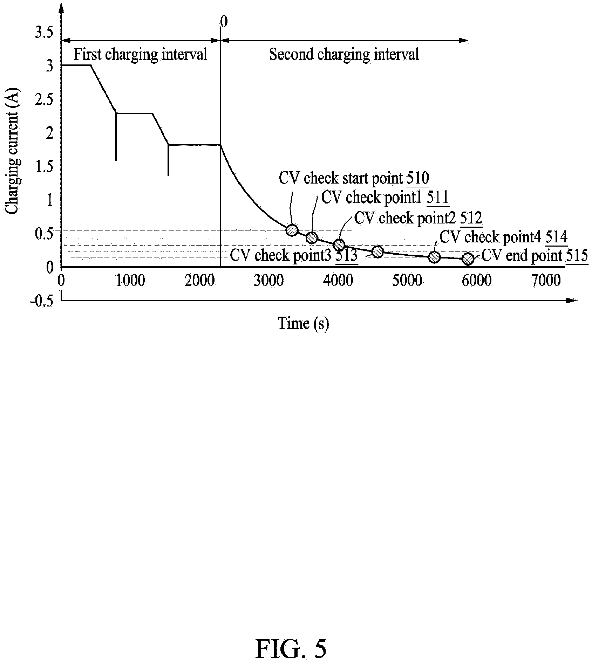

Hereinafter, an operation of estimating (or updating) SOCmax in the first charging interval by the state estimator 120 will be described in detail with reference to FIGS. 4A and 4B, and an operation of estimating (or updating) SOCmax in the second charging interval by the state estimator 120 will be described in detail with reference to FIGS. 5 through 7.

FIGS. 4A and 4B illustrate an example of estimating (or updating) SOCmax in a first charging interval by an electronic device, according to one or more embodiments.

FIG. 4A illustrates a graph of a charging SOC over time. In the graph, the charging SOC may represent an RSOC or an ASOC.

In the example of FIG. 4A, the state estimator 120 may set an initial SOCmax value in a first charging interval. In the example of FIG. 4B, the state estimator 120 may set the initial SOCmax value at a charging start point 410. For example, the state estimator 120 may find an SOCmax value corresponding to a present temperature (e.g., a measured temperature of the battery 110) in a temperature-SOCmax table and may set the found SOCmax as the initial SOCmax value. For another example, when charging in the first charging interval and a second charging interval of FIG. 4A becomes the present charging, SOCmax (or the last updated SOCmax) that is the most recently updated during previous charging immediately before the present charging may be stored in a memory. The state estimator 120 may set the last updated SOCmax in the previous charging as the initial SOCmax value by referring to the memory. For convenience of description, the initial SOCmax value is referred to herein as SOC #1. In interval 1 (i.e., an interval between the charging start point 410 and CC check point 1 411), the initial SOCmax value SOC #1 may be maintained.

The electronic device 100 may calculate a SOC (or voltage) of the battery 110 to request or regulate power (e.g., CC power) from an external power supply (e.g., an adapter or a wireless power transmitter). In this case, the calculated SOC may correspond to the charging start point 410. However, the charging start point 410 is not limited to the foregoing description, and the charging start point 410 may be a point in time at which the electronic device 100 is connected to the external power supply or a point in time at which the electronic device 100 starts receiving power from the external power supply.

For convenience of description, it will be assumed that a SOC value and a time value at the charging start point 410 are SOC $value_0$ and time $t_0$, respectively.

The state estimator 120 may set CC check point 1 411 corresponding to a point (or position) for updating SOCmax in the first charging interval based on a constant SOC interval ($\Delta$SOC) or a predetermined time interval ($\Delta$t). For example, the state estimator 120 may set, as CC check point 1 411, a point where the SOC value has increased by $\Delta$SOC (e.g., 20% or 0.2) from the SOC value (i.e., SOC $value_0$) of the charging start point 410. In this example, a SOC value of CC check point 1 411 may be "SOC $value_0$ + $\Delta$SOC." For another example, the state estimator 120 may set, as CC check point 1 411, a point where time has increased by $\Delta$t (e.g., 10 minutes) from a time value (i.e., $t_0$) of the charging start point 410. In this example, a time value of CC check point 1 411 may be "$t_0$ + $\Delta$t."

The state estimator 120 may calculate resistance values $R_t$ (or an effective resistance value) at respective points of time during time interval 1. The resistance value $R_t$ for a time t may be calculated based on, at the determined point in time t: a measured voltage $value_t$, an estimated OCV $value_t$, and a measured current $value_t$ of the battery 110. The state estimator 120 may calculate the resistance value $R_t$ through Equation 4 below.

### Equation 4

$$R_t = \frac{\text{Measured voltage value}_t - \text{Estimated OCV value}_t}{\text{Measured current value}_t}$$

In Equation 4, t denotes an index of each time (or sample) point in interval 1.

The Estimated OCV $value_t$ may indicate an OCV corresponding to an ASOC of the battery 110 in the aforementioned SOC-OCV table. The state estimator 120 may find an OCV corresponding to an ASOC of the battery 110 in the SOC-OCV table, and use the found OCV as an estimated OCV value (i.e., the estimated OCV $value_t$) of the battery 110 at a time point t.

As the battery 110 is charged, SOC of the battery 110 may increase, and the state estimator 120 may determine whether a state of the battery 110 (e.g., an SOC or a charging time) has reached a state/time corresponding to CC check point 1 411. For example, when the SOC of the battery 110 is greater than or equal to the SOC value (SOC $value_0$ + $\Delta$SOC) of CC check point 1 411, or when the charging time of the battery 110 is greater than or equal to the time value ($t_0$ + $\Delta$t) of CC check point 1 411, the state estimator 120 may determine that the battery 110 has reached CC check point 1 411.

When the battery 110 (or the state of the battery 110) reaches CC check point 1 411, the state estimator 120 may update SOCmax. In an example, the state estimator 120 may derive an average resistance value (or an average effective resistance value) in interval 1 by averaging respective resistance values Rt (or effective resistance values) calculated at the respective time points in interval 1. For example, when $R_1$ to $R_M$ are calculated during interval 1, the state estimator 120 may derive the average resistance value in interval 1 by averaging $R_1$ to $R_M$. The state estimator 120 may update SOCmax using the average resistance value of interval 1, a cutoff current value $I_{cut\_off}$, a cutoff voltage value $V_{cut\_off}$, and SOC-OCV correlation information. For example, to update SOCmax, the state estimator 120 may first compute $OCV_{max}$ by multiplying the average resistance value of interval 1 with the cutoff current value and subtracting a result of the multiplication from the cutoff voltage value. In other words, the state estimator 120 may predict OCVmax of the battery 110 at CC check point 1 411 through Equation 5 below.

### Equation 5

$$OCV_{max} = V_{cut\_off} - \underset{\text{value}}{\text{Average resistance}} \times I_{cut\_off}$$

Having calculated $OCV_{max}$, he state estimator 120 may use the same to estimate SOCmax at CC check point 1 411 or calculate an estimated SOCmax value through Equation 6 below.

$$\text{Equation 6}$$

$$SOC_{max} = f(OCV_{max})$$

In Equation 6, f() is an example of the SOC-OCV correlation information, and may represent a function for calculating SOCmax using OCVmax as a factor or a SOC-OCV curve. As another example of the SOC-OCV correlation information, there may be a SOC-OCV table. Any mapping between SOC and OCV may be used.

When SOCmax estimated at CC check point 1 411 is SOC #2, the state estimator 120 may update SOCmax from the initial value (e.g., SOC #1) to SOC #2.

The state estimator 120 may determine (or calculate) an RSOC of the battery 110 at CC check point 1 411 using $ASOC_1$, the updated SOCmax, and $SOC_{unusable}$ of the battery 110. For example, the state estimator 120 may substitute SOC #2 for SOCmax of Equation 3 "(SOC-$SOC_{unusable}$)/(SOCmax-$SOC_{unusable}$)" and substitute $ASOC_1$ for SOC to calculate the RSOC of the battery 110. That is, the state estimator 120 may determine (or calculate) the RSOC of the battery 110 at CC check point 1 411 based on ($ASOC_1$ - $SOC_{unusable}$)/(SOC #2 - $SOC_{unusable}$).

As described above, the state estimator 120 may periodically update an ASOC using the electrochemical model 310 while the battery 110 is being charged. ASOC, may be the last updated ASOC when the battery 110 has reached CC check point 1 411.

When updating SOCmax as the charging of the battery 110 reaches CC check point 1 411, the state estimator 120 may set CC check point 2 412 as a subsequent/next update point (or position) of SOCmax. For example, the state estimator 120 may set, as CC check point 2 412, a point increased by $\Delta SOC$ (e.g., 20% or 0.2) from a SOC value (hereinafter, referred to as "SOC value,") of the previous CC check point, e.g., CC check point 1 411. A SOC value for determining CC check point 2 412 may be "SOC value, + $\Delta SOC$." For another example, the state estimator 120 may set, as CC check point 2 412, a time point increased by $\Delta t$ (e.g., 10 minutes) from a time value (hereinafter, referred to as "$t_1$") of a previous CC check point, e.g. CC check point 1 411. In this case, the time value of CC check point 2 412 may be "$t_1 + \Delta t$."

In interval 2, SOCmax may be maintained as SOC #2.

For each of points in time during the interval 2 (represented as time t), the state estimator 120 may calculate a resistance value $R_t$ based on a measured voltage value$_t$, an estimated OCV value$_t$, and a measured current value$_t$ of the battery 110, through Equation 4.

As the battery 110 is charged during interval 2, a SOC of the battery 110 may increase, and the state estimator 120 may determine whether the battery 110 has reached CC check point 2 412 based on the SOC of the battery 110 or a charging time. For example, the state estimator 120 may determine whether the SOC of the battery 110 is greater than or equal to the SOC value (SOC value$_1$ + $\Delta SOC$) of CC check point 2 412 or whether the charging time of the battery 110 is greater than or equal to the time value ($t_1 + \Delta t$) of CC check point 2 412.

When the charging of the battery 110 is determined to reach CC check point 2 412 (e.g., when the SOC of the battery 110 is greater than or equal to the SOC value of CC check point 2 412, or when the charging time of the battery 110 is greater than or equal to the time value of CC check point 2 412), the state estimator 120 may update SOCmax. In an example, the state estimator 120 may derive an average resistance value in interval 2 by averaging respective resistance values Rt calculated for respective time points during interval 2. For a detailed description of deriving the average resistance value for interval 2, reference may be made to the foregoing description of deriving the average resistance value for interval 1. The state estimator 120 may update SOCmax using the average resistance value, the cutoff current value, the cutoff voltage value, and the SOC-OCV correlation information in interval 2. For example, the state estimator 120 may predict OCVmax of the battery 110 at CC check point 2 412 through Equation 5, and estimate SOCmax of the battery 110 at CC check point 2 412 through Equation 6.

When SOCmax estimated at CC check point 2 412 is SOC #3, the state estimator 120 may update SOCmax from SOC #2 to SOC #3.

The state estimator 120 may determine (or calculate) an RSOC of the battery 110 at CC check point 2 412 using $ASOC_2$, the updated SOC #3, and $SOC_{unusable}$ of the battery 110. $ASOC_2$ may indicate the last updated ASOC when the battery 110 has reached CC check point 2 412.

When updating SOCmax as the battery 110 reaches CC check point 2 412, the state estimator 120 may set CC check point 3 413 corresponding to a subsequent SOCmax update point (or position). When the battery 110 has reached CC check point 3 413, the state estimator 120 may update SOCmax. For a detailed description of setting CC check point 3 413, reference may be made to the foregoing description of setting CC check point 1 411 and setting CC check point 2 412. For a detailed description of updating SOCmax as the battery 110 reaches CC check point 3 413, reference may be made to the foregoing description of updating SOCmax as the battery 110 reaches CC check point 1 411 and CC check point 2 412.

For convenience of description, when SOCmax estimated at CC check point 3 413 is SOC #4, the state estimator 120 may update SOCmax from SOC #3 to SOC #4.

The state estimator 120 may determine (or calculate) an RSOC of the battery 110 at CC check point 3 413 using $ASOC_3$, the updated SOC #4, and $SOC_{unusable}$ of the battery 110. $ASOC_3$ may indicate the last updated ASOC when the battery 110 has reached CC check point 3 413.

At some time after CC check point 3 413, a voltage of the battery 110 may be determined (e.g., through measurements and comparisons) to become greater than or equal to the cutoff voltage. In this case, the charger 130 may begin to charge the battery 110 in the second charging mode. As described above, the state estimator 120 may not perform a SOCmax estimation operation (or update operation) in the second charging interval, or may perform the SOCmax estimation operation (or update operation) only in the second charging interval, or may perform the SOCmax estimation operation (or update operation) in both the first charging interval and the second charging interval.

According to an embodiment, the first charging interval may be a CC charging interval or an MCC charging interval. When the first charging interval is a CC charging interval, the state estimator 120 may set a CC check point at each predetermined SOC interval or at each predetermined time interval, as described above. When the first charging interval is the MCC charging interval, the state estimator 120 may set a CC check point at each predetermined SOC interval or each predetermined time interval, or may set, as a CC check point, each point at which a magnitude of a current for constant charging changes (time intervals may be set based on detected changes in charging current, based on signals that drive such changes, or by integration with a CC charging system, for example).

FIGS. 5 through 7 illustrate an example of estimating (or updating) SOCmax in a second charging interval by an electronic device.

Referring to FIG. 5, the battery 110 may be charged by MCC charging in a first charging interval. When a voltage of the battery 110 is determined to become greater than or equal to a cutoff voltage, the charger 130 may begin charging the battery 110 in a second charging mode.

In the example of FIG. 5, a CV check start point 510 may be set in correspondence with the start of a second charging interval, and the CV check start point 510 may be preset as an electrical current value (e.g., 0.6A). Although the current value is provided as 0.6A as described above, the current value of the CV check start point 510 is not limited to 0.6A, which is an arbitrary example. Hereinafter, the current value of the CV check start point 510 will be referred to as "$I_0$."

The state estimator 120 may set "$I_0$" as an initial value of a variable cur_now.

The state estimator 120 may periodically measure a charging current of the battery 110 using a current sensor. The state estimator 120 may first determine that a charging current measured at a certain point in time (hereinafter, referred to as a "first measured current value") is less than or equal to an electrical current value (i.e., $I_0$) of the CV check start point 510. The state estimator 120 may later determine that the battery 110 (or the charging current of the battery 110) has reached the CV check start point 510. In this case, the state estimator 120 may set an initial SOCmax value in the second charging interval. For example, the state estimator 120 may set an initial SOCmax value for the second charging interval to be the last updated SOCmax in the first charging interval. In the example described with reference to FIGS. 4A and 4B, the last updated SOCmax in the first charging interval would be SOC #4. In this example, the state estimator 120 may set SOC #4 as an initial SOCmax value for the second charging interval. For another example, the state estimator 120 may not update SOCmax in the first charging interval. In this case, the state estimator 120 may find an SOCmax value that corresponds to a present temperature (e.g., a measured temperature of the battery 110) in a temperature-SOCmax table, and set the thus-found SOCmax value as an initial SOCmax value for the second charging interval. Alternatively, in the example of FIG. 5, when charging in the first charging interval and the second charging interval is collectively referred to as present charging (i.e., "present charging" may be any charging during either interval), the last updated SOCmax which is SOCmax lastly updated in previous charging immediately before the present charging may be stored in a memory. The state estimator 120 may set the last updated SOCmax in the immediately preceding charging as the initial SOCmax value in the second charging interval, by referring to the memory.

When the battery 110 (or a charging current of the battery 110) reaches the CV check start point 510, the state estimator 120 may set CV check point 1 511 as a next point at which an SOCmax update is to be performed, and it may be set based on a constant current interval $\Delta I$ or a constant time interval $\Delta t$. For example, the state estimator 120 may set, as CV check point 1 511, a point obtained by subtracting $\Delta I$ (e.g., 0.1 mA) from a first measured current value. For another example, the state estimator 120 may set, as CV check point 1 511, a point obtained by adding $\Delta t$ (e.g., 10 minutes) to a point in the time at which the battery 110 reaches the CV check start point 510 (or a point in time at which the first measured current value is determined to be $I_0$ or less) (hereinafter, a "first time value").

When the battery 110 reaches the CV check start point 510, the state estimator 120 may set the first measured electrical current value for a variable cur_prev, and set a current value (i.e., the first measured current value - $\Delta I$) of CV

check point 1 511 for a variable cur_now. That is, "cur_prev = first measured current value," and "cur_now = first measured current value - ΔI."

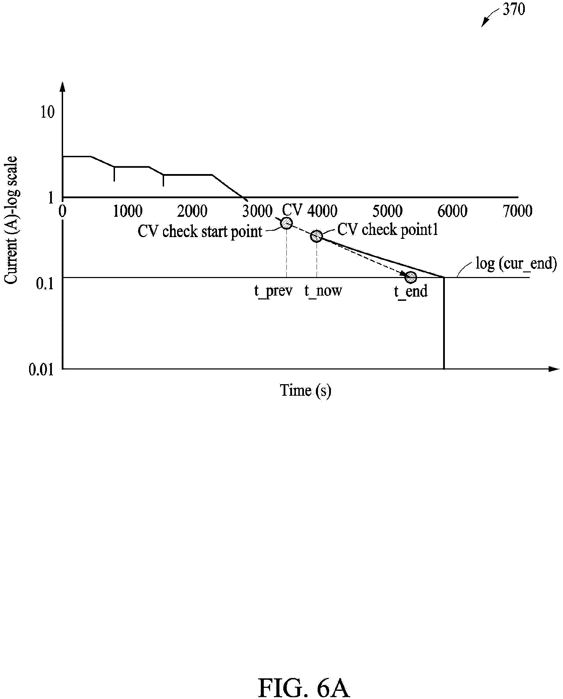

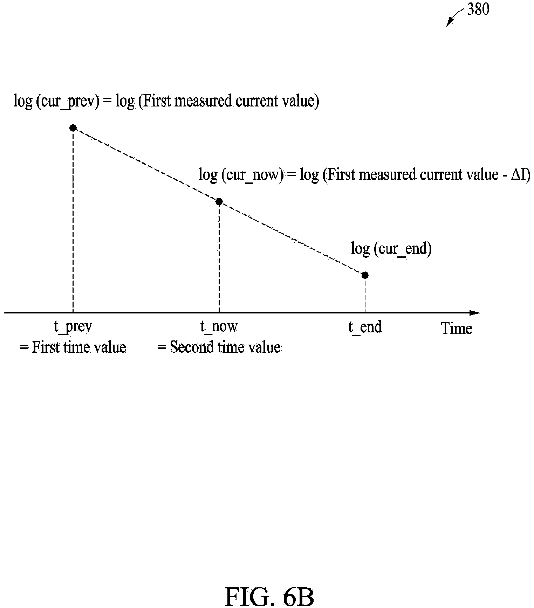

After the CV check start point 510, the state estimator 120 may periodically measure a charging current of the battery 110 using a current sensor. The state estimator 120 may determine that a charging current measured at a certain point (hereinafter, referred to as a "second measured current value") is less than or equal to a current value of CV check point 1 511 (i.e., "first measured current value - ΔI"). That is, the state estimator 120 may determine that the battery 110 (or the charging current of the battery 110) has reached CV check point 1 511. In this case, the state estimator 120 may update SOCmax based on the first measured current value, the current value of CV check point 1 511 (i.e., "first measured current value - ΔI"), a first time value, a second time value, and a cutoff electrical current value. The second time value may indicate a point in time at which the battery 110 reaches CV check point 1 511. Updating SOCmax at CV check point 1 511 will be described below with reference to FIGS. 6A and 6B.

FIG. 6A illustrates a graph of a charging current value (in terms of a logarithmic scale (or log scale)) over time, according to one or more embodiments.

Referring back to FIG. 5, a second charging interval may have a non-linear current attenuation characteristic. When non-linearity is transformed into linearity, a full charge time t_end of FIG. 6A may be predicted more accurately, and the accuracy of SOCmax may be further improved accordingly. The state estimator 120 may transform each of a first measured current value, a current value of CV check point 1 511 (i.e., "first measured current value - Δt"), and a cutoff current value, through a transformation method (e.g., a log scale) that transforms non-linearity into linearity. Although the transformation method of transforming non-linearity into linearity will be described below as a log scale, the transformation method is not limited to the log scale.

In the example 380 shown in FIG. 6B, when the battery 110 reaches CV check point 1 511, the state estimator 120 may set a second time value for a variable t_now and a first time value for a variable t_prev. The second time value may indicate a point in time at which the battery 110 reaches CV check point 1 511 as described above. The state estimator 120 may predict a full charge time t_end (hereinafter, referred to as a first full charge time) of the battery 110 at CV check point 1 511, using Equation 7 below.

### Equation 7

$$t_{end} = \frac{\log(\text{cur\_end}) - \log(\text{cur\_prev})}{\log(\text{cur\_now}) - \log(\text{cur\_prev})} \times (t_{now} - t_{prev}) + t_{prev}$$

As described above, "cur_prev = first measured current value" and "cur_now = first measured current - ΔI." The state estimator 120 may predict the first full charge time, using a log value of the first measured current value, a log value of the "first measured current value - ΔI," a log value of the cutoff current value CV_current_end, the first time value, and the second time value.

When predicting the first full charge time, the state estimator 120 may predict (or calculate) a residual SOC (hereinafter, a first residual SOC) that remains from $t_{now}$ to $t_{end}$, using the cutoff current value, the "first measured current value - ΔI," the predicted first full charge time, the second time value, 3600[sec], and $Q_{max}$. The state estimator 120 may predict (or calculate) the first residual SOC through Equation 8 below.

### Equation 8

$$\Delta SOC\_rest = \frac{\frac{CV\_current\_now + CV\_current\_end}{2} \times (t_{end} - t_{now})}{3600 \times Q_{max}}$$

In Equation 8, ΔSOC_rest denotes a residual SOC that remains until a full charge time, i.e., a time at which the battery 110 is fully charged. In addition, "$t_{end}$ - $t_{now}$" may indicate a predicted time that remains from $t_{now}$ until a time at which the battery 110 is fully charged.

In Equation 8, $Q_{max}$ may denote a total capacity of a battery (e.g., the battery 110). The battery 110 may be degraded, and such a degradation state of the battery 110 may be reflected in a model (e.g., the electrochemical model 310). In this case, $Q_{max}$ may be updated. For example, among various parameters of the electrochemical model 310, a parameter related to the degradation of the battery 110 may be updated. When the parameter related to the degradation of the battery 110 is updated, $Q_{max}$ may be updated.

When predicting the first residual SOC, the state estimator 120 may estimate SOCmax or calculate an estimated SOCmax value, using Equation 9 below.

Equation 9

$$SOC_{max} = ASOC + \triangle SOC\_rest$$

For example, when an initial SOCmax value in the second charging interval is SOC #4 and SOCmax estimated through Equation 9 above is SOC #5, the state estimator 120 may update SOCmax from SOC#4 to SOC #5. When the battery 110 reaches CV check point 1 511, the state estimator 120 may update SOCmax from SOC #4 to SOC #5.

The state estimator 120 may determine (or calculate) an RSOC of the battery 110 using $ASOC_4$, the updated SOC #5, and $SOC_{unusable}$ of the battery 110. $ASOC_4$ being the last updated ASOC when the battery 110 has reached CV check point 1 511.

Referring back to FIG. 5, when updating SOCmax as the battery 110 reaches CV check point 1 511, the state estimator 120 may set CV check point 2 512 corresponding to a point for subsequently updating SOCmax. For example, the state estimator 120 may set, as CV check point 2 512, a point obtained by subtracting $\Delta I$ (e.g., 0.1 mA) from the second measured current value. The state estimator 120 may set the second measured current value for a variable cur_prev, and set a current value of CV check point 2 512 (i.e., the second measured current value - $\Delta I$) for a variable cur_now. That is, "cur_prev = second measured current value" and "cur_now = second measured current value - $\Delta I$."

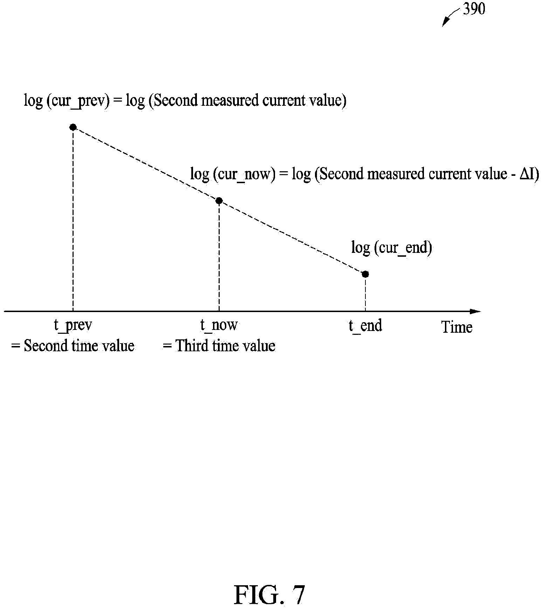

After CV check point 2 512, the state estimator 120 may periodically measure a charging current of the battery 110, using a current sensor. The state estimator 120 may determine that a charging current measured at a certain point (hereinafter, referred to as a "third measured current value") is less than or equal to the current value of CV check point 2 512 (i.e., "second measured current value - $\Delta I$"). That is, the state estimator 120 may determine that the battery 110 has reached CV check point 2 512. In this case, the state estimator 120 may again update SOCmax based on the second measured current value, the current value of CV check point 2 512 (i.e., "the second measured current value - $\Delta I$"), a second time value, a third time value, and the cutoff current value. The third time value may indicate a point in time when the battery 110 reaches CV start point 2 512. Updating SOCmax at CV check point 2 512 will be described below with reference to FIG. 7.

In the example 390 shown in FIG. 7, when the battery 110 reaches CV check point 2 512, the state estimator 120 may set the third time value for a variable t_now and the second time value for a variable t_prev. As described above, "cur_prev = second measured current value" and "cur_now = second measured current value - $\Delta I$." The state estimator 120 may predict a full charge time t_end (hereinafter, referred to as a second full charge time) of the battery 110 at CV check point 2 512, using Equation 7 above. That is, the state estimator 120 may predict the second full charge time, using a log value of the second measured current value, a log value of the "second measured current value - $\Delta I$," a log value of the cutoff current value, the second time value, and the third time value.

When predicting the second full charge time, the state estimator 120 may predict (or calculate) a residual SOC (hereinafter, a second residual SOC) that remains until the predicted second full charge time, using the cutoff electrical current value, the "second measured current value - $\Delta I$," the predicted second full charge time, the third time value, 3600[sec], and $Q_{max}$. The state estimator 120 may predict (or calculate) the second residual SOC through Equation 8.

When predicting the second residual SOC, the state estimator 120 may estimate SOCmax through Equation 9 above. In this case, when the estimated SOCmax is, for example, SOC #6, the state estimator 120 may update SOCmax from SOC #5 to SOC #6. When the battery 110 reaches CV check point 2 512, the state estimator 120 may update SOCmax from SOC #5 to SOC #6.

The state estimator 120 may determine (or calculate) an RSOC of the battery 110 using $ASOC_5$, the updated SOC #6, and $SOC_{unusable}$ of the battery 110. $ASOC_5$ may indicate the last updated ASOC when the battery 110 has reached CV check point 2 512.

Referring back to FIG. 5, when iteratively updating SOCmax as the battery 110 reaches CV check point 2 512, the state estimator 120 may set CV check point 3 513 corresponding to a point for subsequently updating SOCmax. When battery 110 reaches CV check point 3 513, the state estimator 120 may iteratively update SOCmax. The state estimator 120 may set CV check point 4 514, and iteratively update SOCmax when the battery 110 reaches CV check point 4 514.

A measured current value of the battery 110 may be less than or equal to the cutoff electrical current value. That is, the battery 110 may reach a CV end point 515. In this case, a processor (e.g., an application processor (AP)) may determine that the battery 110 is fully charged and may determine to end charging. Upon the determination of the end of charging, the state estimator 120 may determine (or calculate) an RSOC of the battery 110, using the last updated SOCmax in the second charging interval (e.g., SOCmax updated when the battery 110 reaches CV check point 4 514), the last updated ASOC in the second charging interval, and $SOC_{unusable}$. The state estimator 120 may transmit the determined RSOC to the processor. The processor may display the determined RSOC on a display to provide it to a user. Accordingly, when it is determined that the battery 110 is fully charged, it is possible to prevent a situation in which the RSOC is forcibly jumped to 100% (i.e., the value displayed to user changes suddenly to 100%), and it is thus possible to provide a more accurate RSOC to the user.

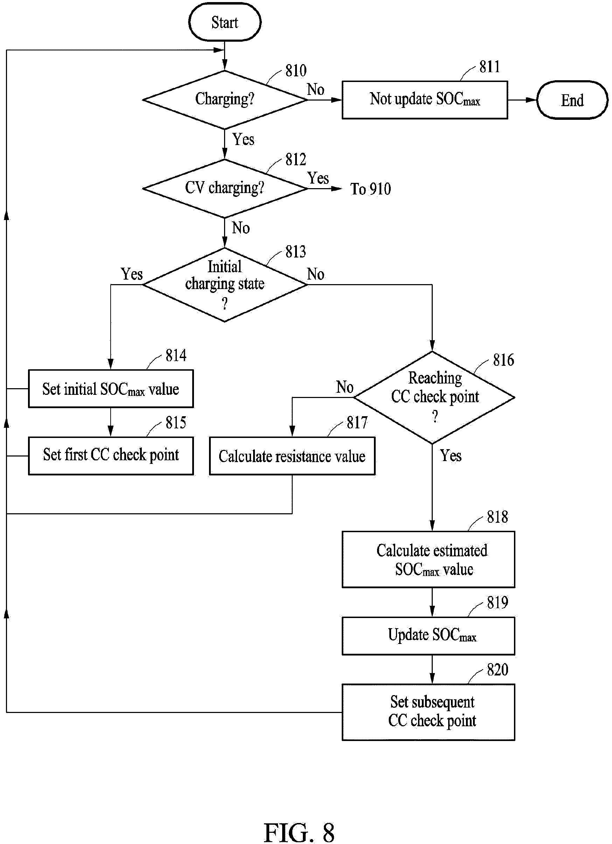

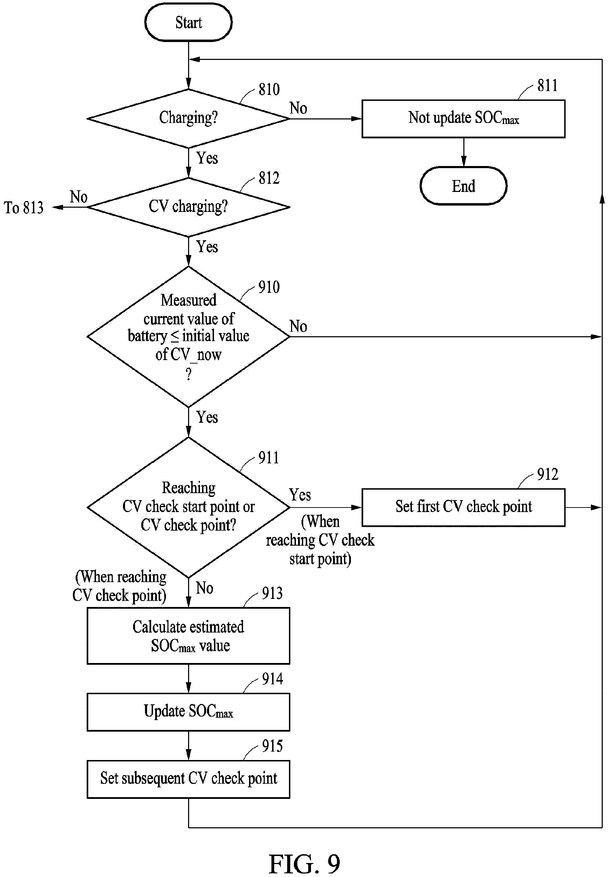

FIGS. 8 and 9 illustrate examples of estimating (or updating) SOCmax by an electronic device, according to one or more embodiments.

Referring to FIG. 8, in operation 810, the electronic device 100 may determine whether the battery 110 is being charged. The electronic device 100 may determine that the battery 110 is being charged until a determination to end charging is made.

In operation 811, when it is determined in operation 810 that the battery 110 is not being charged, the electronic device 100 may not update SOCmax.

In operation 812, when it is determined in operation 810 that the battery 110 is being charged, the electronic device 100 may determine whether the battery 110 is being charged through CV charging.

The electronic device 100 may perform operation 910 when the battery 110 is being charged through CV charging, and perform operation 813 when the battery 110 is not being charged through CV charging (e.g., when the battery 110 is being charged through CC charging or MCC charging).

In operation 813, the electronic device 100 may determine whether the battery 110 (or the electronic device 100) is in an initial charging state. The initial charging state may refer to, for example, a state in which the electronic device 100 is at the charging start point 410 of FIG. 4A.

In operation 814, when the electronic device 100 is in the initial charging state, the electronic device 100 may set an initial SOCmax value in a CC interval. For the setting of the initial SOCmax value, reference may be made to what has been described above with reference to FIG. 4B.

In operation 815, the electronic device 100 may set a first CC check point corresponding to a point for updating SOCmax. For example, the electronic device 100 may set CC check point 1 411 described above with reference to FIGS. 4A and 4B.

When performing operation 815, the electronic device 100 may perform operations 810, 812, and 813. Since the electronic device 100 sets CC check point 1 411, the electronic device 100 may determine that the battery 110 is not in the initial charging state in operation 813, and may perform operation 816.

In operation 816, the electronic device 100 may determine whether the battery 110 has reached the CC check point. For example, the electronic device 100 may determine whether the battery 110 has reached CC check point 1411.

In operation 817, when the battery 110 has been determined to have not reached CC check point 1 411, the electronic device 100 may calculate a resistance value Rt using Equation 4.

When operation 817 has been performed, the electronic device 100 may again perform operations 810, 812, 813, and 816. Unlike the example described with reference to FIG. 8, when performing operation 817, the electronic device 100 may perform operation 816 without performing operations 810, 812, and 813 (i.e., operations 816 and 817 may loop directly). The electronic device 100 may calculate a resistance value Rt at each of points in time in interval 1 between the charging start point 410 and CC check point 1 411. A pause or delay may be included in each resistance-calculating iteration to avoid excessive sampling and calculating.

In operation 818, when the battery 110 reaches the CC check point 1 411, the electronic device 100 may calculate an estimated SOCmax value. For example, as described above with reference to FIG. 4B, the electronic device 100 may predict OCVmax of the battery 110 using an average resistance value, a cutoff current value, and a cutoff voltage value of interval 1, through Equation 5 above. In addition, the electronic device 100 may calculate the estimated SOCmax value through Equation 6 above.

In operation 819, the electronic device 100 may update SOCmax. For example, the electronic device 100 may update SOCmax from the initial SOCmax value to the estimated SOCmax value calculated as described above.

In operation 820, the electronic device 100 may set a subsequent CC check point at a point for subsequently updating SOCmax. For example, the electronic device 100 may set CC check point 2 412 described above with reference to FIGS. 4A and 4B.

When setting the subsequent CC check point, the electronic device 100 may perform operations 810, 812, 813, and 816 again. According to implementation, when setting the subsequent CC check point, the electronic device 100 may perform operation 816 without performing operations 810, 812, and 813.

In operation 816, the electronic device 100 may determine whether the battery 110 has reached the subsequent CC check point. The electronic device 100 may perform operation 817 when the battery 110 does not reach the subsequent CC check point, and may perform operations 818, 819, and 820 again when the battery 110 reaches the subsequent CC check point.

Although not shown in FIG. 8, at any of various times the electronic device 100 may determine whether a measured voltage value of the battery 110 is greater than or equal to the cutoff voltage value. When the measured voltage value of the battery 110 is greater than or equal to the cutoff voltage value, the electronic device 100 may switch to a CV mode to charge the battery 110.

In some embodiments, SOCmax may not be updated during CV charging. In this case, the last updated SOCmax during CC charging may be maintained during the CV charging. When determining that the battery 110 is fully charged, the electronic device 100 may determine an RSOC of the battery 110 based on the last updated SOCmax during the CC charging.

In other embodiments, SOCmax may be updated during the CV charging. In this case, the electronic device 100 may determine that the battery 110 is being charged through the CV charging in operation 812, and perform operation 910 of FIG. 9. The SOCmax update during the CV charging will be described below with reference to FIG. 9.

Referring to FIG. 9, in operation 910, the electronic device 100 may determine whether a first measured current value of the battery 110 is less than or equal to an initial value of cur_now. For example, the electronic device 100 may determine whether the battery 110 reaches the CV check start point 510 of FIG. 5. The initial value of cur_now may correspond to a current value at the CV check start point 510.

Although not shown in FIG. 9, the electronic device 100 may set an initial SOCmax value in CV charging. As described above with reference to FIG. 8, when the SOCmax update is performed while the battery 110 is being charged through CC charging, the electronic device 100 may set the initial SOCmax value in the CV charging to be the SOCmax lastly updated during the CC charging In some embodiments, the electronic device 100 may not update SOCmax during the CC charging. In this case, the electronic device 100 may set SOCmax corresponding to a present temperature (e.g., a measured temperature of the battery 110) to be the initial SOCmax value in the CV charging. Alternatively, when the CC charging and the CV charging are referred to as present charging, the electronic device 100 may set SOCmax lastly updated during the present charging (i.e., either CC or CV charging) to be the initial SOCmax value in the CV charging.

When it is determined in operation 910 that the first measured current value of the battery 110 is greater than the initial value of cur_now, the electronic device 100 may perform operations 810, 812, and 910 again. According to implementation, when it is determined that the first measured current value of the battery 110 is greater than the initial value of cur_now, the electronic device 100 may perform operation 910 again without necessarily performing operations 810 and 812 (i.e., operation 910 may repeat until its condition is met).

In operation 911, when the first measured current value of the battery 110 is less than or equal to the initial value of cur_now, the electronic device 100 may determine whether the battery 110 has reached a CV check start point or a CV check point.

In operation 912, when the battery 110 is determined to reach the CV check start point in operation 911, the electronic device 100 may set a first CV check point corresponding to a first point for updating SOCmax. For example, as described above with reference to FIG. 5, the electronic device 100 may set CV check point 1 511. Also, in operation 912, the electronic device 100 may set the first measured current value for cur_prev and set a value of "first measured current value$_a$ - $\Delta I$" for in cur_now.

When performing operation 912, the electronic device 100 may perform operations 810, 812, 910, and 911. According to implementation, when performing operation 912, the electronic device 100 may perform operation 911 without performing operations 810, 812, and 910.

In operation 911, the electronic device 100 may determine whether the battery 110 has reached the CV check start point or the first CV check point. When the battery 110 charging has passed the CV check start point, the electronic device 100 may not perform operation 912 any longer. When the battery 110 has not yet reached the first CV check point, the electronic device 100 may iteratively perform operation 911.

In operation 913, when the battery 110 reaches the first CV check point, the electronic device 100 may calculate an estimated SOCmax value. For example, as described above with reference to FIG. 6B, the electronic device 100 may set a second time value for t_now and set a first time value for t_prev. In this case, "cur_prev = first measured current value" and "cur_now = first measured current value - $\Delta I$." The electronic device 100 may predict a first full charge time using Equation 7, predict a first residual SOC using Equation 8, and calculate an estimated SOCmax value using Equation 9.

In operation 914, the electronic device 100 may update SOCmax. For example, the electronic device 100 may update SOCmax from the initial SOCmax value of the CV charging to the estimated SOCmax value calculated as described above.

In operation 915, the electronic device 100 may set a subsequent CV check point at a point for subsequently updating SOCmax. For example, the electronic device 100 may set CV check point 2 512, as shown in FIG. 5.

When setting the subsequent CV check point, the electronic device 100 may perform operations 810, 812, 910, 911, 913, and 914 again. In some implementations, when setting the subsequent CV check point, the electronic device 100 may perform operations 911, 913, and 914 without performing operations 810, 812, and 910.

Although not shown in FIG. 9, the electronic device 100 may determine whether a measured electrical current value of the battery 110 is less than or equal to a cutoff current value. When the measured current value of the battery 110 is less than or equal to the cutoff current value, the electronic device 100 may determine that the battery 110 is fully charged and end charging. In association with determining that the battery 110 is fully charged, the electronic device 100 may determine an RSOC by using an ASOC that is lastly updated during the CV charging, $SOC_{unusable}$, and SOCmax that is lastly updated during the CV charging, and may provide the determined RSOC to a user.

What has been described above with reference to FIGS. 1 through 7 may apply to the operations described with reference to FIGS. 8 and 9.

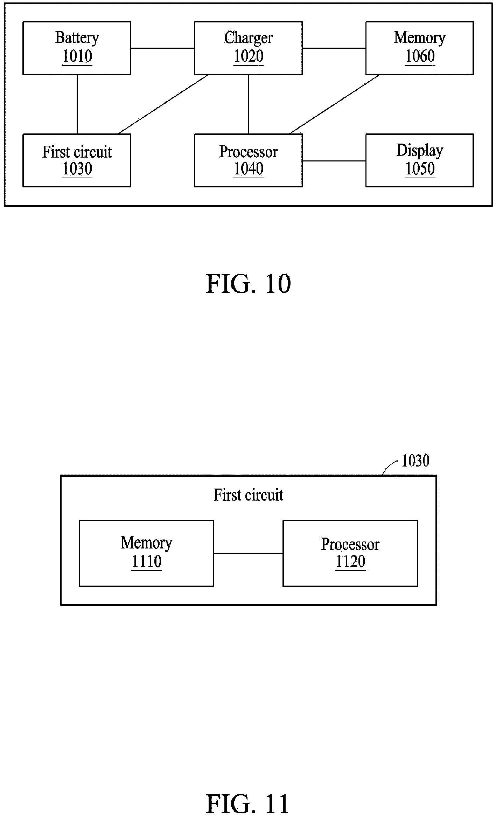

FIG. 10 illustrates an example configuration of an electronic device, according to one or more embodiments. FIG. 11 illustrates an example configuration of a first circuit of an electronic device, according to one or more embodiments.

Referring to FIG. 10, an electronic device 1000 may include a battery 1010, a charger 1020, a first circuit 1030, a processor 1040, a display 1050, and a memory 1060.

The electronic device 1000 of FIG. 10 may be an example of the electronic device 100 described above.

The charger 1020 may correspond to the charger 130 of FIG. 1 and may charge the battery 1010 in a first charging mode and in a second charging mode.

The first circuit 1030 may perform the operations of the state estimator 120 described above.

The first circuit 1030 may correspond to a "fuel" gauge circuit.

The charger 1020 and the first circuit 1030 may be implemented as a single integrated circuit (e.g., a power management integrated circuit (PMIC)). The PMIC may supply power stored in the battery 1010 to various components (e.g., the processor 1040, the display 1050, and the memory 1060) of the electronic device 1000, in addition to performing charging. For example, the power management circuit may adjust the power stored in the battery 1010 to a voltage or current level suitable for each of the processor 1040, the display 1050, and the memory 1060, and may supply power of which the voltage or current level is correspondingly adjusted to each of the processor 1040, the display 1050, and the memory 1060.

The processor 1040 may control the overall operation of the electronic device 1000.

The processor 1040 may perform various data processing steps or operations and may store results of the data processing steps or operations in the memory 1060.

The memory 1060 may be a volatile memory or a non-volatile memory (not a signal per se).

The memory 1060 may store therein various programs (e.g., an operating system (OS), middleware, and/or one or more applications). The applications may include a system application and a third-party application.

The processor 1040 may correspond to an application processor (AP).

The first circuit 1030 may determine (or estimate) SOCmax, an ASOC, and an RSOC of the battery 1010. The first circuit 1030 may update the ASOC through a battery model (e.g., the electrochemical model 310) during charging of the battery 1010 and may update SOCmax as described above. In addition, the first circuit 1030 may determine the RSOC using the updated ASOC, the updated SOCmax, and $SOC_{unusable}$. The processor 1040 may receive the RSOC of the battery 1010 from the first circuit 1030 and may display the RSOC of the battery 1010 on the display 1050.

The first circuit 1030 may be electrically connected to the charger 1020 and the battery 1010.

The first circuit 1030 may include, for example, a memory 1110 and a processor 1120 as shown in FIG. 11. The processor 1120 of FIG. 11 may include, for example, a micro controller unit (MCU) or an application-specific integrated circuit (ASIC), but examples of which are not limited thereto.

The processor 1120 of the first circuit 1030 may perform the operations of the state estimator 120 described above. The memory 1110 may include one or more instructions executable by the processor 1120. The memory 1110 may store therein a SOC-OCV table. According to embodiments, the memory 1110 may store therein a temperature-SOCmax table.

The processor 1120 may execute the instructions stored in the memory 1110 to perform the operations of the state estimator 120 (or the first circuit 1030). According to implementation, the processor 1040 of FIG. 10 may perform a part of the operations of the processor 1120 of FIG. 11.

In an example, the first circuit 1030 may iteratively update SOCmax while the battery 1010 is being charged in a first charging mode (e.g., a CC charging mode). The first circuit 1030 may iteratively update SOCmax while the battery 1010 is being charged in a second charging mode (e.g., a CV charging mode). In this case, a SOCmax update method (e.g., a first method) in the first charging mode and a SOCmax update method (e.g., a second method) in the second charging mode may be different from each other.

In the first method, the first circuit 1030 may determine whether the battery 1010 being charged in the first charging mode (or a state (e.g., a SOC or time) of the battery 1010) has reached a first point for updating SOCmax. The first point may be, for example, any one of the CC check points 411 through 413 described above.

When it is determined that the battery 1010 (or the state of the battery 1010) has reached the first point, the first circuit 1030 may calculate an average resistance value of the battery 1010 for a predetermined time interval before the first point. For example, when the battery 1010 (or the state of the battery 1010) reaches CC check point 1 411 of FIG. 4, the first circuit 1030 may calculate an average resistance value of the battery 1010 for interval 1. In this example, the first circuit 1030 may calculate a resistance value at each of points in time in interval 1 using Equation 4 above, and average the calculated resistance values to calculate the average resistance value of the battery 1010 for interval 1. Similarly, when the battery 1010 (or the state of the battery 1010) reaches CC check point 2 412 of FIG. 4, the first circuit 1030 may calculate an average resistance value of the battery 1010 for interval 2. Also, when the battery 1010 (or the state of the battery 1010) reaches CC check point 3 413 of FIG. 4, the first circuit 1030 may calculate an average resistance value of the battery 1010 for interval 3.

The first circuit 1030 may update SOCmax based on SOC-OCV correlation information (e.g., a SOC-OCV table or a SOC-OCV curve, mapping, etc.), the calculated average resistance value, the cutoff current value, and the cutoff voltage value. For example, the first circuit 1030 may multiply the calculated average resistance value and the cutoff current value, predict a difference between the cutoff voltage value and a result of the multiplication as an OCV when the battery 1010 is fully charged, determine a SOC corresponding to the predicted OCV using the SOC-OCV correlation information, and update SOCmax based on the determined SOC.

The first circuit 1030 may determine an RSOC of the battery 1010 using the updated SOCmax, the ASOC of the battery 1010, and $SOC_{unusable}$. The ASOC may be the last updated ASOC when the battery 1010 reaches the first point in the first charging mode.

The charger 1020 may switch from the first charging mode to the second charging mode to charge the battery 1010 in the second charging mode.

In the second method, the first circuit 1030 may compare a first measured current value of the battery 1010 being charged in the second charging mode to a current value of a preset start point, and determine whether the battery 1010 (or a state of the battery 1010 (e.g., a measured current value)) has reached the preset start point. The preset start point may correspond to the CV check start point 510 described above.

As the first measured current value becomes less than or equal to the current value of the preset start point, the first circuit 1030 may determine that the battery 1010 has reached the preset start point. In this case, the first circuit 1030 may set a second point for updating SOCmax. The second point may correspond to CV check point 1 511 described above.

The first circuit 1030 may determine whether the battery 1010 (or the state of the battery 1010 (e.g., the measured current value)) has reached the set second point.

When the charging of the battery 1010 (or the state of the battery 1010 (e.g., the measured current value)) has reached the set second point, the first circuit 1030 may predict a full charge time of the battery 1010 and predict a residual SOC that remains until the battery 1010 is fully charged based on the predicted full charge time. For example, the first circuit 1030 may predict the full charge time based on a first time value of a time at which the battery 1010 reaches the preset start point, a second time value of a time at which the battery 1010 reaches the second point, a transformed value of the first measured current value, a transformed value of a result obtained by subtracting a predetermined value from the first measured current value, and a transformed value of the cutoff current value. In this case, the transformed value of the first measured current value, the transformed value of the result obtained by subtracting the predetermined value from the first measured current value, and the transformed value of the cutoff current value may be values obtained by transforming the first measured current value, the result value obtained by subtracting the predetermined value from the measured current value, and the cutoff current value into a log scale, respectively. The first circuit 1030 may predict the residual SOC based on the predicted full charge time, the second time value, the result value obtained by subtracting the predetermined value from the first measured current value, and the cutoff current value.

The first circuit 1030 may iteratively update SOCmax based on the predicted residual SOC. For example, the first circuit 1030 may update SOCmax again based on a sum of the predicted residual SOC and the updated ASOC of the battery 1010.

When the battery 1010 is fully charged, the first circuit 1030 may determine an RSOC of the battery 1010 by using the last updated SOCmax, the last updated ASOC, and $SOC_{unusable}$. The first circuit 1030 may transmit the determined RSOC to the processor 1040. The processor 1040 may display the determined RSOC on the display 1050.

What has been described above with reference to FIGS. 1 through 9 may apply to the description provided above with reference to FIGS. 10 and 11.

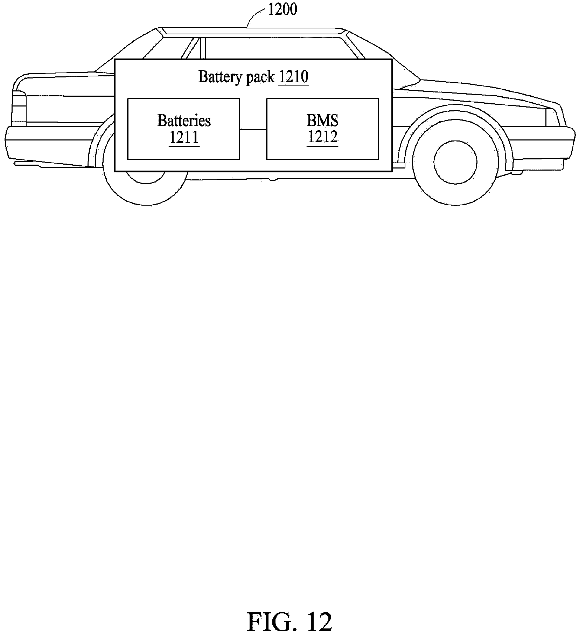

FIG. 12 illustrates an example of a vehicle, according to one or more embodiments.

Referring to FIG. 12, a vehicle 1200 may include a battery pack 1210, and the battery pack 1210 may include batteries 1211 and a battery management system (BMS) 1212.

The vehicle 1200 may use the batteries 1211 as a power source. The vehicle 1200 may be, for example, an electric vehicle, a hybrid vehicle, or an autonomous vehicle.

The batteries 1211 may be battery modules, each of which may include one or more battery cells.

The BMS 1212 may monitor whether there is an abnormality occurring in the batteries 1211 to prevent the batteries 1211 from being over-charged or over-discharged. In addition, the BMS 1212 may perform thermal control for the batteries 1211 when a temperature of the batteries 1211 is greater than a first temperature (e.g., 40°C) or is less than a second temperature (e.g., -10°C). In addition, the BMS 1212 may perform cell balancing to equalize respective charging states of battery cells included in the batteries 1211.

The BMS 1212 may perform the operations of the state estimator 120 described above. For example, the BMS 1212 may estimate state information (e.g., an ASOC and an RSOC) of each battery cell included in the batteries 1211. In this example, the BMS 1212 may determine, as the state information of the battery pack 1210, a maximum value, a minimum value, or an average value of the estimated state information of each battery cell.

The BMS 1212 may transmit the state information of the battery pack 1210 to an electronic control unit (ECU) or a vehicle control unit (VCU) of the vehicle 1200. The ECU or VCU of the vehicle 1200 may output the state information of the batteries 1211 to a display (e.g., an instrument panel or a heads-up display (HUD)) of the vehicle 1200.

What has been described above with reference to FIGS. 1 through 9 may apply to the description provided above with reference to FIG. 12, and thus a more detailed and repeated description will be omitted here for conciseness.

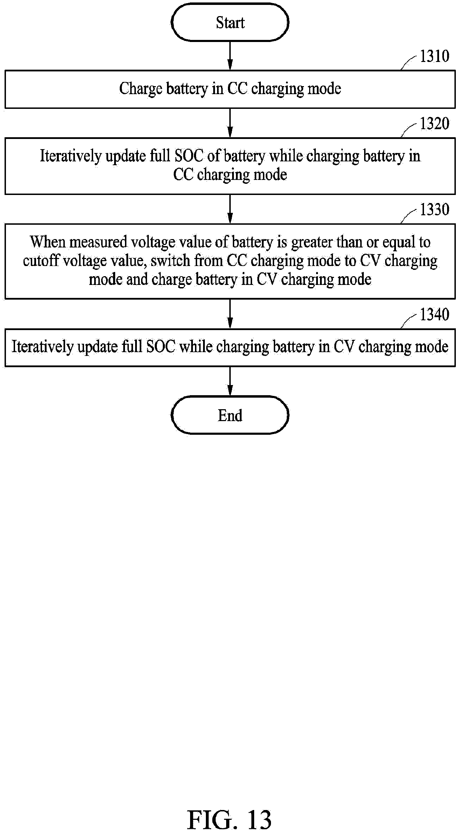

FIG. 13 illustrates an example of an operating method of an electronic device, according to one or more embodiments.

Referring to FIG. 13, in operation 1310, an electronic device (e.g., the electronic device 100 or 1000) may charge a battery (e.g., the battery 110 or 1010) in a CC charging mode.

In operation 1320, the electronic device may iteratively update SOCmax of the battery while charging the battery in the CC charging mode.

In operation 1330, when a measured voltage value of the battery is greater than or equal to a cutoff voltage value, the electronic device may switch from a CC charging mode to a CV charging mode and charge the battery in the CV charging mode.

In operation 1340, the electronic device may iteratively update SOCmax while the battery is being charged in the CV charging mode.

What has been described above with reference to FIGS. 1 through 12 may apply to the operating method described above with reference to FIG. 13, and thus a more detailed and repeated description will be omitted here for conciseness.

The computing apparatuses, the vehicles, the electronic devices, the processors, the memories, the displays, the information output system and hardware, the storage devices, and other apparatuses, devices, units, modules, and components described herein with respect to FIGS. 1-13 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-13 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the disclosure may also be defined by the claims.

**Claims**

1. A method comprising:

    charging a battery in a constant current, CC, charging mode;
    iteratively updating a full state of charge, SOC, value of the battery while in the CC charging mode;
    when a measured voltage value of the battery is determined to be greater than or equal to a cutoff voltage value, switching from the CC charging mode to a constant voltage, CV, charging mode and charging the battery in the CV charging mode; and
    iteratively updating the full SOC value while in the CV charging mode.

2. The method of claim 1, wherein the iteratively updating the full SOC value in the CC charging mode comprises:

    determining whether charging of the battery has reached a point for updating the full SOC value;
    when determined that the charging of the battery has reached the point, calculating an average resistance value of the battery for an interval before the point;
    updating the full SOC value based on correlation information correlating SOC and open-circuit voltage, OCV, the calculated average resistance value, a cutoff current value, and the cutoff voltage value;

setting a subsequent point for updating the full SOC value; and

when the battery reaches the set subsequent point, iteratively updating the full SOC value based on an average resistance value of the battery for an interval between the point and the subsequent point, the correlation information, the cutoff current value, and the cutoff voltage value.

3. The method of claim 2, wherein the calculating the average resistance value comprises at points during the interval, calculating a resistance value using a measured voltage value, an estimated OCV value, and a measured electrical current value of the battery; and calculating the average resistance value by averaging the calculated resistance values, or

wherein the updating the full SOC value based on the correlation information, the calculated average resistance value, the cutoff current value, and the cutoff voltage value comprises multiplying the calculated average resistance value with the cutoff current value; predicting, as an OCV of the battery when the battery is fully charged, a difference value between the cutoff voltage value and a result of the multiplying; and determining an SOC corresponding to the predicted OCV using the correlation information, and updating the full SOC value based on the determined SOC.

4. The method of one of claims 1 to 3, wherein the iteratively updating the full SOC value in the CV charging mode comprises:

determining whether charging the battery has reached a start point by comparing a first measured current value of the battery being charged in the CV charging mode to a current value at the preset start point;

when the charging the battery reaches the start point, setting a point for updating the full SOC value;

determining whether the charging the battery has reached the set point;

when the charging the battery reaches the set point, predicting a full charge time of the battery and predicting a residual SOC that remains until the battery is fully charged, based on the predicted full charge time; and

updating the full SOC value based on the predicted residual SOC.

5. The method of claim 4, wherein the iteratively updating the full SOC value in the CV charging mode comprises setting a subsequent point for updating the full SOC value; when the battery reaches the set subsequent point, iteratively predicting a full charge time of the battery, and iteratively predicting a residual SOC that remains until the battery is fully charged, based on the iteratively predicted full charge time; and iteratively updating the full SOC value based on the iteratively predicted residual SOC, or

wherein the predicting the residual SOC comprises predicting the full charge time based on a first time value of a time at which charging the battery has reached the preset start point, a second time value of a time at which charging the battery has reached the preset point, a transformed value of the first measured current value, a transformed value of a result value derived by subtracting a predetermined value from the first measured current value, and a transformed value of the cutoff current value; and predicting the residual SOC based on the predicted full charge time, the second time value, the result value, and the cutoff current value.

6. The method of claim 5, wherein the transformed value of the first measured current value, the transformed value of the result value, and the transformed value of the cutoff current value are values obtained through a logarithmic transformation of the first measured current value, the result value, and the cutoff current value, or

wherein the predicting the full charge time comprises:

calculating a first difference value between the transformed value of the cutoff current value and the transformed value of the first measured current value;

calculating a second difference value between the transformed value of the result value and the transformed value of the first measured current value;

calculating a third difference value between the second time value and the first time value; and

predicting the full charge time using the calculated first difference value, the calculated second difference value, the calculated third difference value, and the first time value.

7. The method of one of claims 1 to 6, wherein a method of updating the full SOC value in the CC charging mode differs from a method of updating the full SOC value in the CV charging mode, or

the method further comprises updating an absolute SOC, ASOC, of the battery using a battery model; determining whether the battery is fully charged; when the battery is determined to be fully charged, determining a relative SOC, RSOC, of the battery using a lastly updated full SOC value, the updated ASOC, and an unusable SOC; and displaying an indication of the determined RSOC.

8. A non-transitory computer-readable storage medium having instructions that, when performed by a processor, cause the processor to perform the steps of:

    charging a battery in a constant current, CC, charging mode;
    updating a full state of charge, SOC, value of the battery according to a first method while in the CC charging mode;
    when a measured voltage value of the battery satisfies a cutoff voltage value, switching from the CC charging mode to a constant voltage, CV, charging mode and charging the battery in the CV charging mode; and
    updating, in association with the CV charging mode, the full SOC value according to a second method that is different from the first method.

9. The computer-readable storage medium of claim 8, wherein the updating the full SOC value according to the first method comprises determining whether charging the battery has reached a point for updating the full SOC value; when determined that the charging the battery has reached the point, calculating an average resistance value of the battery for an interval before the point; and updating the full SOC value based on correlation information correlating SOC values and open-circuit voltage, OCV, values, the calculated average resistance value, a cutoff current value, and the cutoff voltage value, or

    wherein the calculating the average resistance value comprises at points during the interval, calculating a resistance value using a measured voltage value, an estimated OCV value, and a measured current value of the battery; and calculating the average resistance value by averaging the calculated resistance values, or
    wherein the updating the full SOC value based on the correlation information, the calculated average resistance value, the cutoff current value, and the cutoff voltage value comprises multiplying the calculated average resistance value with the cutoff current value; predicting, as an OCV of the battery when the battery is fully charged, a difference value between the cutoff voltage value and a result of the multiplying; and determining an SOC corresponding to the predicted OCV using the correlation information, and updating the full SOC value based on the determined SOC.

10. The computer-readable storage medium of claim 8 or 9, wherein the updating the full SOC value in association with the second method comprises:

    determining whether the battery has reached a start point by comparing a first measured current value of the battery in the CV charging mode to a current value at the preset start point;
    when the charging the battery reaches the preset start point, setting a point for updating the full SOC value;
    determining whether the battery has reached the set point;
    when the charging of the battery reaches the set point, predicting a full charge time of the battery and predicting a residual SOC that remains until the battery is fully charged, based on the predicted full charge time; and
    updating the full SOC value based on the predicted residual SOC.

11. The computer-readable storage medium of claim 9, wherein the predicting the residual SOC comprises:

    predicting the full charge time based on a first time value of a time at which the battery has reached the start point, a second time value of a time at which the battery has reached the point, a transformed value of the first measured electrical current value, a transformed value of a result value derived by subtracting a predetermined value from the first measured current value, and a transformed value of the cutoff current value; and
    predicting the residual SOC based on the predicted full charge time, the second time value, the result value, and the cutoff current value.

12. The computer-readable storage medium of claim 11, wherein the transformed value of the first measured current value, the transformed value of the result value, and the transformed value of the cutoff current value are values obtained through a transformation of the first measured current value, the result value, and the cutoff current value into a logarithmic scale, respectively, or
    wherein the predicting the full charge time comprises calculating a first difference value between the transformed value of the cutoff current value and the transformed value of the first measured current value; calculating a second difference value between the transformed value of the result value and the transformed value of the first measured current value; calculating a third difference value between the second time value and the first time value; and predicting the full charge time using the calculated first difference value, the calculated second difference value, the calculated third difference value, and the first time value.

**13.** The computer-readable storage medium of one of claims 8 to 12, further comprising:

updating an absolute SOC, ASOC, of the battery using a battery model;
determining whether the battery is fully charged;
when the battery is fully charged, determining a relative SOC, RSOC, of the battery using a lastly updated full SOC value, the updated ASOC, and an unusable SOC; and
displaying an indication of the determined RSOC.

**14.** An electronic device, comprising:

a battery;
a charger configured to charge the battery in a constant current, CC, charging mode, and charge the battery in a constant voltage, CV, charging mode when a condition is determined to be satisfied;
a first circuit configured to update a full state of charge, SOC, value of the battery according to a first method while in the CC charging mode, update the full SOC of the battery according to a second method while in the CV charging mode, and determine a relative SOC, RSOC, of the battery using a lastly updated value of the full SOC value, an absolute SOC, ASOC, of the battery, and an unusable SOC; and
a processor configured to receive the determined RSOC from the first circuit and provide an indication of the received RSOC.

**15.** The electronic device of claim 14, wherein, in the first method, the first circuit is configured to determine whether the battery has reached a point for updating the full SOC value; and when the point is reached, calculate an average resistance value of the battery for an interval before the point, and update the full SOC value based on correlation information correlating SOC values with open-circuit voltage, OCV, values, the calculated average resistance value, a cutoff current value, and the cutoff voltage value, or

wherein, in the second method, the first circuit is configured to determine whether the battery has reached a start point by comparing a first measured current value of the battery in the CV charging mode to a current value at the start point; when the charging the battery reaches the start point, set a point for updating the full SOC value; determine whether the charging the battery has reached the set point; when determined that the charging the battery has reached the set point, predict a full charge time of the battery, and predict a residual SOC that remains until the battery is fully charged, based on the predicted full charge time; and update the full SOC value based on the predicted residual SOC, or
wherein the first circuit is configured to iteratively update the full SOC value of the battery according to the first method while in the CC charging mode, and iteratively update the full SOC value of the battery according to the second method while in the CV charging mode.

100

| Battery<br>110 | | State estimator<br>120 |

| Charger<br>130 |

FIG. 1

FIG. 2

FIG. 3A

FIG. 3B

FIG. 3C

FIG. 4A

Charge start point

CC check point 1

CC check point 2

$(410)$ ——— Interval 1 ——— $(411)$ ——— Interval 2 ——— $(412)$ · · ·

Set initial
$SOC_{max}$ value

Update $SOC_{max}$

Update $SOC_{max}$

# FIG. 4B

FIG. 5

FIG. 6A

380

log (cur_prev) = log (First measured current value)

log (cur_now) = log (First measured current value - $\Delta I$)

log (cur_end)

t_prev
= First time value

t_now
= Second time value

t_end

Time

# FIG. 6B

390

log (cur_prev) = log (Second measured current value)

log (cur_now) = log (Second measured current value - ΔI)

log (cur_end)

t_prev       t_now       t_end     Time
= Second time value    = Third time value

FIG. 7

FIG. 8

**FIG. 9**

FIG. 10

FIG. 11

FIG. 12

```
                          ┌─────────────┐
                          │    Start    │
                          └─────────────┘
                                 │
                                 ▼                          ╱ 1310
        ┌────────────────────────────────────────────────────┐
        │        Charge battery in CC charging mode          │
        └────────────────────────────────────────────────────┘
                                 │
                                 ▼                          ╱ 1320
        ┌────────────────────────────────────────────────────┐
        │  Iteratively update full SOC of battery while      │
        │  charging battery in CC charging mode              │
        └────────────────────────────────────────────────────┘
                                 │
                                 ▼                          ╱ 1330
        ┌────────────────────────────────────────────────────┐
        │ When measured voltage value of battery is greater  │
        │ than or equal to cutoff voltage value, switch from │
        │ CC charging mode to CV charging mode and charge    │
        │ battery in CV charging mode                        │
        └────────────────────────────────────────────────────┘
                                 │
                                 ▼                          ╱ 1340
        ┌────────────────────────────────────────────────────┐
        │ Iteratively update full SOC while charging battery │
        │ in CV charging mode                                │
        └────────────────────────────────────────────────────┘
                                 │
                                 ▼
                          ┌─────────────┐
                          │     End     │
                          └─────────────┘
```

# FIG. 13

Europäisches
Patentamt

European
Patent Office

Office européen
des brevets

# EUROPEAN SEARCH REPORT

Application Number

EP 23 16 1470

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 975 897 B2 (YOSHIOKA SHOJI [JP]; TABUCHI AKIKO [JP] ET AL.) 10 March 2015 (2015-03-10) | 1-6,8-12 | INV. H02J7/00 |
| Y | * figure 3 * <br> * column 2, line 37 * <br> * column 2, line 42 * <br> * column 4, line 4 – line 12 * <br> * column 5, line 44 – line 50 * <br> * column 1, line 6 – line 9 * <br> * column 9, line 31 – line 54 * <br> * column 11, line 5 – column 52 * <br> ----- | 7,13-15 | |
| Y | US 9 846 201 B2 (RENESAS ELECTRONICS CORP [JP]) 19 December 2017 (2017-12-19) <br> * figures 1,3,10,12 * <br> * column 11, line 23 – line 35 * <br> * column 22, line 65 – column 23, line 3 * <br> * column 23, line 3 – line 7 * <br> * column 17, line 7 – line 30 * <br> ----- | 7,13-15 | |
| Y | JP 2013 178166 A (SANYO ELECTRIC CO) 9 September 2013 (2013-09-09) <br> * paragraph [0033] – paragraph [0034] * <br> ----- | 7,13 | TECHNICAL FIELDS SEARCHED (IPC) <br><br> H02J <br> G01R |
| A | JP 2022 002460 A (LENOVO SINGAPORE PTE LTD) 6 January 2022 (2022-01-06) <br> * figure 4 * <br> * paragraph [0046] * <br> ----- | 1,8,14 | |

The present search report has been drawn up for all claims

| Place of search | Date of completion of the search | Examiner |
|---|---|---|
| Munich | 29 September 2023 | Despis, Enguerran |

## ANNEX TO THE EUROPEAN SEARCH REPORT
## ON EUROPEAN PATENT APPLICATION NO.

EP 23 16 1470

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2023

| Patent document cited in search report | | Publication date | Patent family member(s) | Publication date |
|---|---|---|---|---|
| US 8975897 | B2 | 10-03-2015 | AU 2010354957 A1 | 13-12-2012 |
| | | | BR 112012027318 A2 | 02-08-2016 |
| | | | CN 102918411 A | 06-02-2013 |
| | | | EP 2579059 A1 | 10-04-2013 |
| | | | JP 5511951 B2 | 04-06-2014 |
| | | | JP WO2011155017 A1 | 01-08-2013 |
| | | | KR 20120139818 A | 27-12-2012 |
| | | | RU 2012155314 A | 20-07-2014 |
| | | | US 2013027047 A1 | 31-01-2013 |
| | | | WO 2011155017 A1 | 15-12-2011 |
| US 9846201 | B2 | 19-12-2017 | JP 2012247339 A | 13-12-2012 |
| | | | US 2012306450 A1 | 06-12-2012 |
| | | | US 2015177331 A1 | 25-06-2015 |
| | | | US 2018100897 A1 | 12-04-2018 |
| JP 2013178166 | A | 09-09-2013 | NONE | |
| JP 2022002460 | A | 06-01-2022 | CN 113904395 A | 07-01-2022 |
| | | | DE 102021115714 A1 | 23-12-2021 |
| | | | EP 3930139 A1 | 29-12-2021 |
| | | | GB 2599766 A | 13-04-2022 |
| | | | JP 7027488 B2 | 01-03-2022 |
| | | | JP 2022002460 A | 06-01-2022 |
| | | | US 2021399567 A1 | 23-12-2021 |

EPO FORM P0459

For more details about this annex : see Official Journal of the European Patent Office, No. 12/82